# EUROPEAN PATENT SPECIFICATION

(11) **EP 3 220 072 B1**
(45) Date of publication and mention of the grant of the patent: **12.05.2021**
(21) Application number: 17160947.2
(22) Date of filing: 14.03.2017
(51) Int. Cl.: F24F 13/08, H05K 7/20

(54) **VENTILATION APPARATUS**
VENTILATOR
APPAREIL DE VENTILATION

(30) Priority: 14.03.2016 IT UA20161618
(43) Date of publication of application: 20.09.2017
(73) Proprietor: Hiref S.p.A., 35020 Tribano (IT)
(72) Inventor: MANTOVAN, Mauro, 35020 TRIBANO (IT); POLETTO, Fabio, 35020 TRIBANO (IT)
(74) Representative: Cataldi, Giulia

(56) References cited:
- EP-A1- 2 587 175
- EP-A1- 2 587 180
- CN-A- 104 456 724
- DE-A1- 1 428 214
- US-A1- 2009 324 403

## Description

This patent application relates to a ventilation apparatus and to an air conditioning machine.

Air conditioning machines are used to cool down data processing centres, also known as data centres, namely structures where there are many electronic apparatuses.

In order to cool down said data centres, air conditioning machines are used, which are installed in rooms with a raised floor. These air conditioning machines comprise ventilation apparatuses, similar to cabinets, which are applied to the raised floor in a substantially modular manner and have a ventilation chamber, which is arranged under the floor. These ventilation apparatuses comprise a bearing structure, which delimits the ventilation chamber, and one or more fans, which are

installed in the ventilation chamber, under the raised floor. The fans as well as the ventilation chambers are configured to push cooling air under the floor and then the cooling air is conveyed through grids or conduits inside the data centres. These machines with underfloor air flow are known for example from EP 2587175 A1.

Known air conditioning machines suffer from the drawback that the air flow flowing out of the fan is deflected in an unexpected and disorderly manner by the bearing structures. This leads to the creation of turbulence areas, which cause a loss of energy, besides a very bad distribution of the air relative to the total area available for the outflow.

It is also known by US 2009/0324403 A1 a ventilation apparatus comprising stationary air foils. However, this kind of ventilation apparatus does not permit to optimize both the outlet of the flow of air from the ventilation chamber and the distribution as well as the directing of the flow of air outside the support structure.

The object of the invention is to provide a ventilation apparatus and an air conditioning machine, which overcome the drawbacks described above. In particular, the object of the invention is to provide a ventilation apparatus and an air conditioning machine, in which turbulences inside the ventilation chamber are minimized or even eliminated.

According to the invention, there are provided a ventilation apparatus and an air conditioning machine according to the appended claims.

The invention will now be described with reference to the accompanying drawings, which show non-limiting embodiments thereof, wherein:
- figure 1 is a perspective view of an air conditioning machine according to the invention;

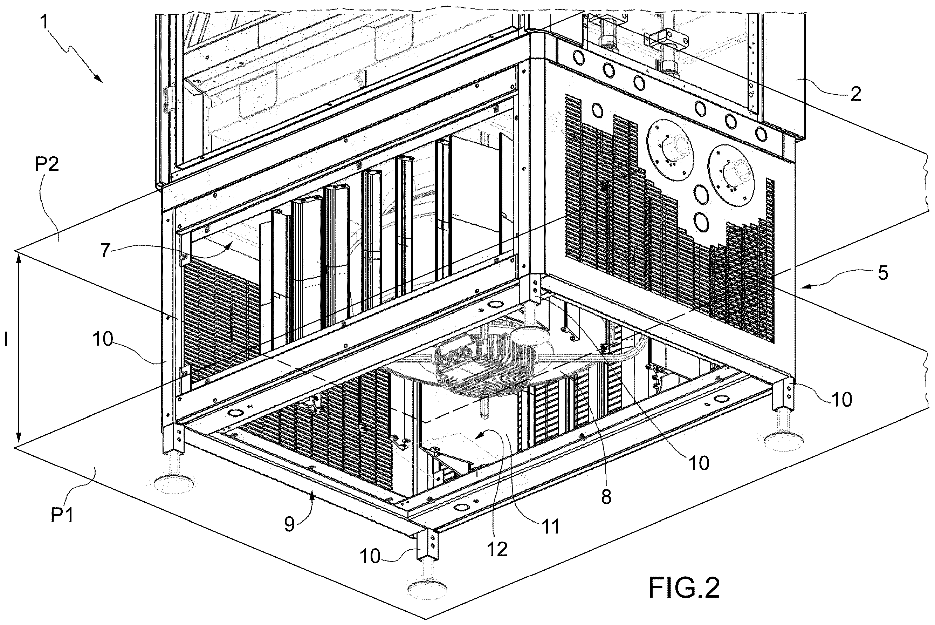

- figure 2 shows a detail of figure 1;
- figure 3 is a plan view of an apparatus according to the invention;
- figure 4 is a schematic plan view, partially exploded, of a variant of the apparatus of figure 3;
- figure 5 shows a first detail of figure 4;
- figure 6 shows a second detail of figure 4.

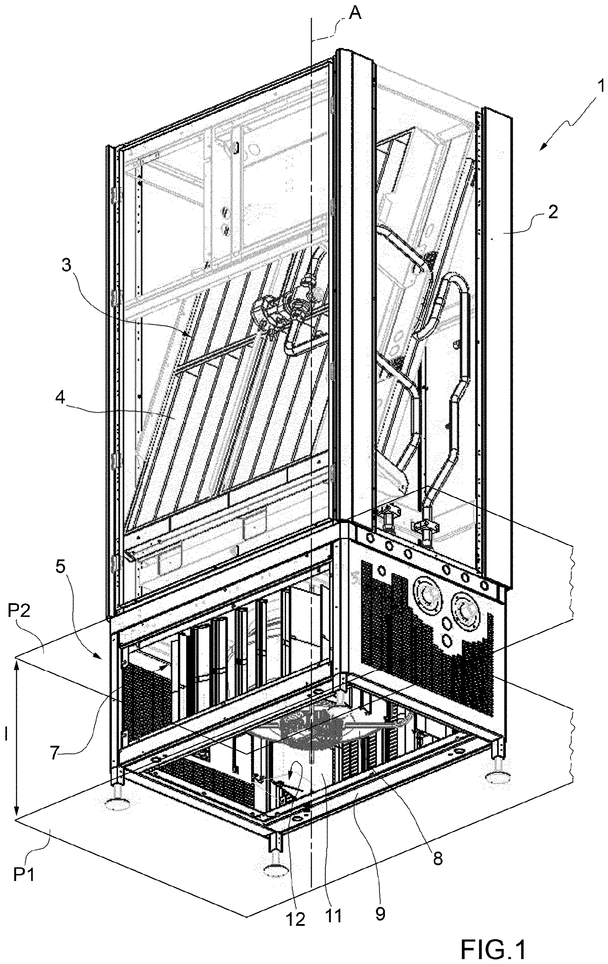

In figure 1, number 1 indicates, as a whole, an air conditioning machine, in particular for cooling down data centres, which involves the passage of air W from a low-pressure zone (usually known as intake) to a high-pressure zone (usually known as delivery).

The air conditioning machine 1 is configured to be installed inside rooms that have a support surface P1 and a raised floor P2, which is raised relative to said support surface P1, so as to obtain a hollow space I for the passage of electric material and for the passage and the distribution of cooling air W.

According to figure 1, the machine 1 comprises a cabinet 2 having a longitudinal axis A and a ventilation apparatus 5. The cabinet 2 projects above the floor P2 and contains, on the inside, an air conditioning system 3, in particular a heat exchange unit 4 to obtain cold air W. The ventilation apparatus 5 axially projects under the cabinet 2 and is configured to be installed inside a hollow space I between the support surface P1 and a raised floor P2.

The ventilation apparatus 5 is in fluid communication with the cabinet 2 and is configured to suck the cold air W from the inside of the cabinet 2 and to convey it into the hollow space I between the support surface P1 and the floor P2.

According to the figures, the ventilation apparatus 5 comprises a support structure 6, which has a ventilation chamber 7, and one or more centrifugal fans 8. Each fan 8 comprises, in a known manner, an impeller and a plurality of blades (schematically shown in the figures). Preferably, the fans 8 are centrifugal fans with backward-curved blades.

The support structure 6 comprises a frame 9, which comprises, in turn, a plurality of uprights 10 to laterally delimit the ventilation chamber 7 where one or more fans 8 are installed.

The example represented in figure 1 shows an air conditioning machine 1 with one single fan 8; alternatively, the air conditioning machine 1 can comprise two or more fans 8, which can be installed beside one another in a modular manner.

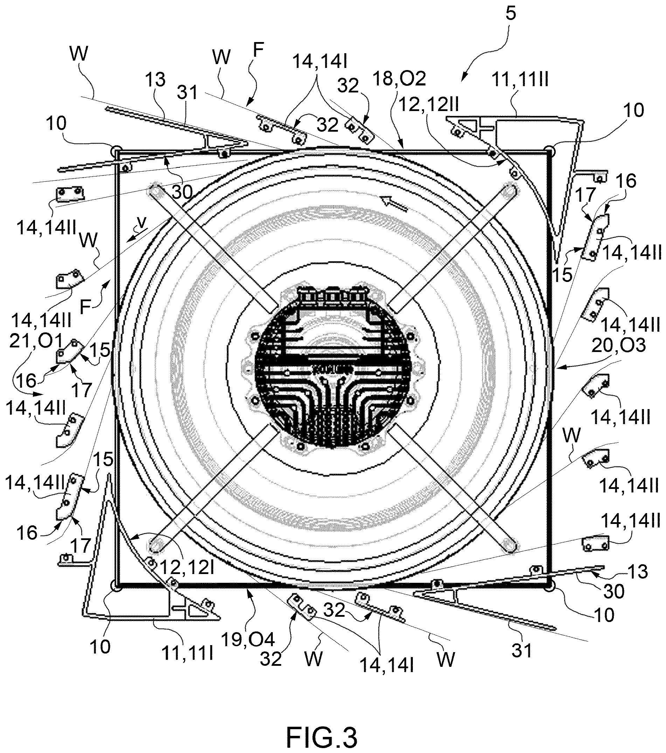

Figure 3 shows, in a plan view with some parts removed for greater clarity, a ventilation apparatus 5 comprising one single fan 8.

According to figure 3, the ventilation apparatus 5 comprises, in turn, at least one partition 11, which is installed close to respective upright 10, so as to be interposed between the fan 8 and the upright 10 itself. Each partition 11 comprises a substantially plate-shaped body, which extends along the axis A. Each partition 11 comprises a curved portion 12, which has a concavity facing the fan 8.

Each partition 11 is configured to deflect the fluid threads of the air W flowing out of the fan 8, so as to avoid the formation of turbulence areas or the stagnation of the air W.

According to the example shown in figure 3, the ventilation apparatus 5 comprises two opposite partitions 11I and 11II In particular, the curved portion 121 of the partition 11I and the curved portion 12II of the partition 11II are arranged so as to screen two opposite uprights 10 and on a same diagonal of the ventilation apparatus 5. In this way, the two partitions 11I and 11II cause the air W flowing out of the fan 8 to be subjected to a uniform motion.

In the example shown in figure 3, the ventilation apparatus 5 further comprises blades 13, each having a substantially plate-shaped body. Each blade 13 has a flat wall 30, which is arranged close to a respective upright 10 and/or wall of the support structure 6, so as to linearly convey the fluid threads of the air W out of the ventilation chamber 7 along a direction that is substantially tangential to the fan 8.

The assembly made up of a partition 11 and a respective blade 13 substantially simulates the action of a screwpump, namely Archimedes' screw, of a fan. However, each partition 11 has the advantage, compared to a common screwpump of a fan 8, of having a reduced weight as well as a limited size; furthermore, the dimensions and the inclination of the partitions 11 can be changed based on both the size and the shape of the support structure 6 on which they must be applied and the shape and the size of the fan 8. Furthermore, the partitions 11 can also be easily installed on already existing support structures 6.

The apparatus shown in figure 3 further comprises a plurality of wings 14, each mounted close to an opening O1, 03 for the passage of the air W from the inside of the ventilation chamber 7 towards the outside of the support structure 6. Each wing 14 has a substantially plate-shaped body, which extends longitudinally to the axis A.

In particular, the ventilation apparatus 5 comprises single wings 14I or double wings 14II. The single wings 14I substantially have one single contact wall 32 in contact with the flow of air W, whereas the double wings 14II have two contact walls 15, 16 in contact with the flow of air W.

In particular, each double wing 14II has an inner wall 15, an outer wall 16 and a connector 17 between the inner wall 15 and the outer wall 16. Advantageously, the inner wall 15 of each wing 14 is arranged so as to be tangent to the direction of the absolute speed v of the air W flowing out of the fan 8. The direction of the absolute speed v of the air W is a function, in a known manner, of the geometry and of the speed of rotation ω of the fan 8.

Each outer wall 16 is inclined relative to the inner wall 15 as a function of the desired direction to be given to the flow of air W flowing out of the ventilation chamber 7.

According to the example shown in figure 3, the support structure 6 has, in its plan view, a substantially square shape with four sides 18, 19, 20 and 21 that are substantially orthogonal to one another. The ventilation apparatus 5 comprises two partitions 11, which are installed, as already mentioned before, on two opposite uprights 10 of a same diagonal of the support structure 6. Each partition 11 has an extension along the axis A that is substantially equivalent to the extension of the hollow space I between the support surface P1 and the floor P2, so as to completely screen the respective upright 10 inside the ventilation chamber 7. The partitions 11 have walls exposed to the flow of air W that are substantially smooth and without obstacles, namely hindrances.

In figure 3 you can see the fixing tabs of the partitions 11 and the wings 14, which project in correspondence of the longitudinal ends of the partitions 11.

The ventilation apparatus 5 comprises, furthermore, two blades 13, which are installed close to the other two opposite uprights 10 on the same diagonal of the support structure 6.

Advantageously, the assembly descried above, made up of the partitions 11 and the blades 13, causes the flow of air W flowing out of the fan 8 to be subjected to a motion that is similar to the one to which the flow of air W would be subjected under the action of two equal and opposite screwpumps. Therefore, the combination of the partitions 11 and the blades 13 described above optimizes the flow of air W inside the ventilation chamber 7 and, at the same time, optimizes the distribution of the flow of air W outside the ventilation chamber 7.

The support structure 6 is a structure that is substantially formed by a frame 9 open on the side or, at the most, having perforated panels. Hence, the air W flowing out of the fan 8 is distributed on the outside on all the sides 18, 19, 20, 21 of the support structure 6.

In particular, the solution described in figure 3 has two opposite side openings O1, O3, which make up to preferential distribution openings for the air W on the outside. In particular, the partitions 11 and the blades 13 of the ventilation apparatus shown in figure 3 are configured to convey the greatest part of the flow of air W through the openings O1, O3.

Advantageously, the ventilation apparatus 5 further comprises, in correspondence of the openings O1, O3, a plurality of double wings 14II. The double wings 1411 arranged close to the openings O1 and O3 direct the flow of air W flowing out of the ventilation chamber 7 so as to a have an optimal distribution of the air W outside the ventilation chamber 7 and so as to reduce turbulences as much as possible. In particular, the inclination of the outer walls 16 of the double wings 14II is a function of the inclination to be given to the flow of air W flowing out of the ventilation chamber 7.

Advantageously, the ventilation apparatus 5 comprises a plurality of single wings 141, which are installed close to the openings O2 and O4 of the support structure. The single wings 14I are arranged in such a way that their wall is substantially tangent to the direction of the absolute speed v of the flow of air W close to corresponding position along the respective opening O2 or O4. In this way, the flow of air W flowing out of the support structure 6 is optimized, thus minimizing losses of load due to turbulences.

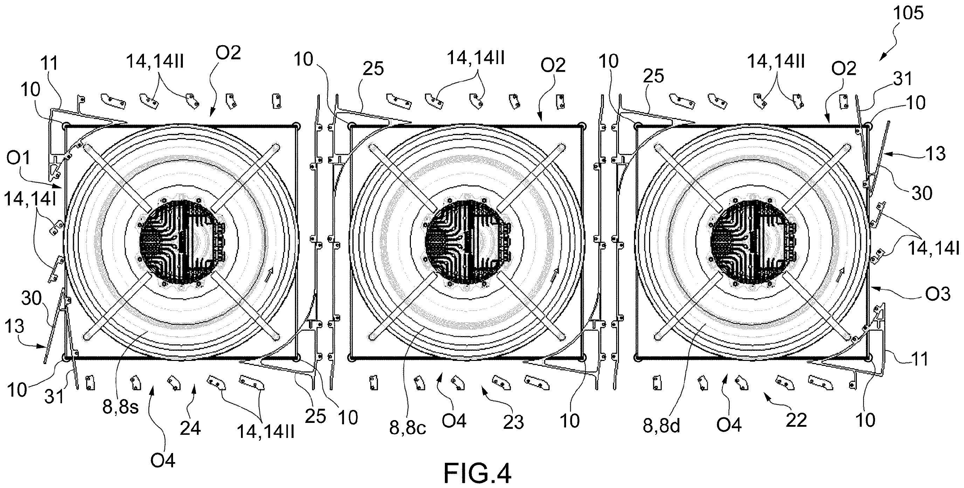

Figure 4 shows a variant of the ventilation apparatus 5 shown in figure 3. In figure 4, the components shared with the ventilation apparatus 5 of figure 3 maintain the same reference numbers and are considered as comprised in said apparatus without describing them again, for the sake of brevity. In particular, figure 4 shows a ventilation apparatus 105 comprising three fans 8 beside one another.

According to figure 4, the ventilation apparatus 5 has a shape that is substantially rectangular in its plan view.

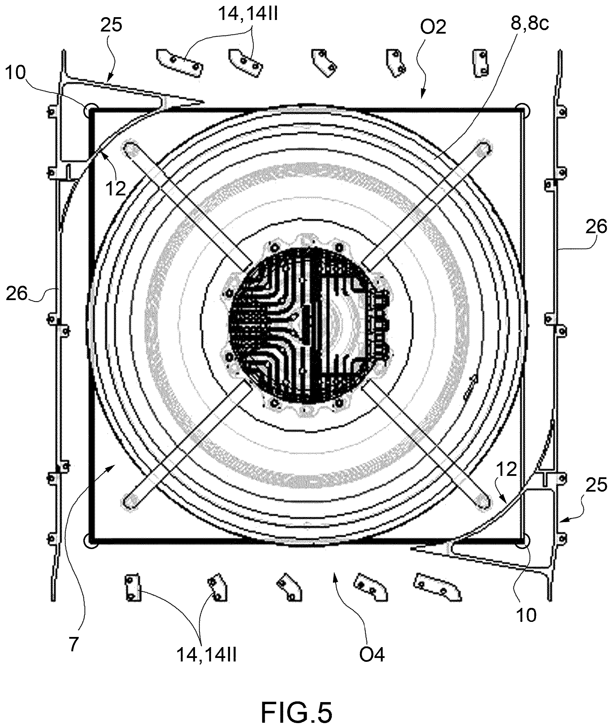

The ventilation apparatus 105 comprises, in particular, three fans 8 beside one another and arranged inside three ventilation chambers 7 aligned with one another. In particular, the ventilation apparatus 5 comprises: a central fan 8c (shown in detail in figure 5), a right fan 8d, and a left fan 8s.

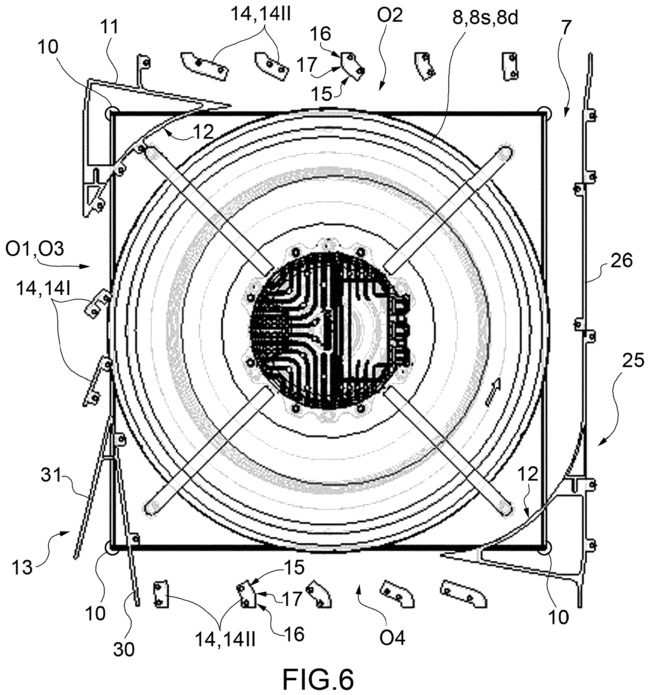

The right and left fans 8d, 8s have the same structure mounted in a mirror-like manner. Figure 6 shows an example of left fan 8s, said structure substantially corresponding to the structure of a right fan 8d.

According to figure 5, the central fan 8 comprises two extended partitions 25, each engaging a respective upright 10 and a respective side of the support structure 6. Each extended partition 25 comprises a curved portion 12 and a straight portion 26. The curved portion 12 is configured to be installed close to an upright 10, whereas a straight portion 26 is configured to extend inside the ventilation chamber 7 and to screen a side opening 0 of the ventilation chamber 7.

Advantageously, the combination of two extended partitions 25 is configured to cause the flow of air W flowing out of the fan 8 to be subjected to a motion that is similar to the one that would be generated by two equal and opposite screwpumps. In particular, the extended partitions 25 preferentially convey the flow of air W towards the openings 02, 04, which face the larger side surfaces of the ventilation apparatus 5.

According to figures 4 and 5, the ventilation apparatus 5 comprises, furthermore, a plurality of double wings 14II, which are arranged close to both the opening O2 and the opening O4. The double wings 14II direct the flow of air W flowing out of the ventilation chamber 7 in a preferred direction.

According to figure 6, the left fan 8s (or right fan) comprises an extended partition 25, which is installed along one side (in case of the right fan 8d) so as to prevent the flow of air W generated by the central fan 8 from interfering with the flow of air W generated by the left fan 8s (or right fan). The left fan 8s further comprises an extended partition 25, which is installed inside the respective ventilation chamber 7 in correspondence of the upright 10 that is diagonally opposite to the one where the curved portion 12 of the extended partition 25 is arranged. The left fan 8s (or right fan) comprises, furthermore, a blade 13, which is installed close to the adjacent upright. Said blade 13 advantageously has two flat walls 30, 31, which are incident with one another and have a vertex facing the curved portion 2 of the partition 11. The blade 13, in accordance with what described above, is configured to cause the flow of air W flowing out of the fan 8 to be subjected to a motion that is similar to the one that would be generated by a screwpump, namely Archimedes' screw. Furthermore, the presence of the double flat walls 30 and 31 arranged in a V-shape allows the flow of air W to be divided linearly and to the directed in a linear manner either through the opening 0 or through the opening 0. By so doing, the likelihood of turbulences of the air W flowing out of the ventilation chamber 7 is reduced. Furthermore, it is ensured that the air W is directed according to preferential paths.

Advantageously, the left fan 8s has a plurality of double wings 14II, which are arranged close to the openings that face the front and rear surface of the ventilation apparatus 5. Furthermore, the ventilation apparatus 5 has a plurality of single wings 14I, which are arranged along the opening that faces the left surface of the ventilation apparatus 5.

In use, the air W present inside a data centre is conveyed into the cabinet 2 and cooled down in a known manner by the air conditioning system 3, in particular by means of the heat exchange unit 4. The cooled air W present inside the cabinet 2 is caused to return into the ventilation apparatus 5 by each fan 8, which, by rotating, also makes sure that cold air W is distributed outside the ventilation chamber 7.

The presence of the partitions 11 in combination with the blades 13 or the presence of the extended partitions 25 allows the support structure 6 to be screened, so as to eliminate possible points of turbulence inside the ventilation chamber 7. Furthermore, the presence of the partitions 11 in combination with the blades 13 or the presence of the extended partitions 25 allows the flow of air W flowing out of the fan 8 to be subjected to a motion that is similar to the one that would be generated by a double screwpump with opposite outlet openings. It is evident that such a result could not be obtained with two opposite screwpumps due to evident problems in terms of space taken up, difficulty and manufacturing costs.

Furthermore, the presence of the single wings 14I or of the double wings allows the air W to be optimally and uniformly distributed all around the ventilation chamber 7. As a matter of fact, this ventilation apparatus 5 is configured to be advantageously used both in structures where the flow of air W must be channelled inside suitable conduits made in the hollow space I and in case the hollow space I must be put under pressure by the cooling air W without the presence of a preferential channelling.

Owing to the above, the ventilation apparatus 5 is simple and economic to be manufactured, can also be easily applied in already existing support structures 6, and the geometry of the partitions 11, of the blades 13 and of the wings 14 can be studied so as to optimize the flow of air W flowing out of the ventilation chamber 7 as a function both of the dimensions and the shape of support structure 6 and of the dimensions and the geometry of the fan 8.

Furthermore, the particular arrangement of the partitions 11 and of the blades 13 allows the flow of air W flowing out of the fan 8 to be subjected to a motion that is similar to the one that would be generated by two screwpumps with opposite distribution openings for the air W. Therefore, the ventilation apparatus 5 described above allows you to optimize both the outlet of the flow of air W from the ventilation chamber 7 and the distribution as well as the directing of the flow of air W outside the support structure 6.

## Claims

1. A ventilation apparatus, in particular for air conditioning machines (1) involving the passage of air (W) from a low-pressure zone to a high-pressure zone, comprising a quadrangular support structure (6), which delimits one or more ventilation chambers (7), and a fan (8; 8c, 8s, 8d) for each ventilation chamber (7);the apparatus comprising one or more partitions (11; 25), each mounted inside the ventilation chamber (7) so as to radially deflect the flow of air (W) flowing out of the fan (8; 8c, 8s, 8d) in correspondence of a respective corner of the ventilation chamber (7) itself; the apparatus comprising wings (14; 14I; 14II) having a wall (15) that is tangent to the direction of the absolute speed of the flow of air (W) flowing out of the fan (8; 8c, 8s, 8d); said wings having an inner wall (15) and an outer wall (16) at an angle relative to one another; the apparatus (5; 105) being **characterized in that** it comprises a plurality of double and single wings (14; 14I; 14II) arranged in correspondence of respective openings (O1, O2, O3, O4) of the support structure (6); wherein the double wings (14II) have an inner wall (15), an outer wall (16) and a connector (17) between the inner wall (15) and the outer wall (16) ; wherein the inner wall (15) is tangent to the direction of the absolute speed (v) of the flow of air (W) flowing out of the fan (8; 8c, 8s, 8d) ; wherein the outer wall (16) is inclined relative to said inner wall as a function of the direction to be given to the flow of air (W) flowing out of the respective ventilation chamber (7).

2. A ventilation apparatus according to claim 1 and comprising a blade (13) which is installed inside the respective ventilation chamber (7) in correspondence of a corner that is adjacent to the one where said partition (11; 25) is mounted; wherein the combination of the geometry of the partition (11; 25) and of the blade (13) is configured to cause the flow of air (W) flowing out of the fan (8; 8c, 8s, 8d) to be subjected to a motion that is similar to the one of a screwpump, namely Archimedes' screw.

3. An apparatus according to claim 2 and comprising a pair of partitions (11; 25) and a pair of blades (13); wherein the partitions (11; 25) are arranged at opposite corners on a same diagonal of the ventilation chamber (7); wherein the blades (13) are arranged close to the other two opposite corners of a diagonal; wherein the assembly made up of the partitions (11; 25) and the blades (13) is configured to cause the flow of air (W) flowing out of the fan (8; 8c, 8s, 8d) to be subjected to a motion that simulates the motion of air (W) caused by two screwpumps, namely Archimedes' screws, with distribution openings that are opposite and parallel to one another.

4. An apparatus according to any of the preceding claims and comprising a plurality of fans (8; 8s, 8c, 8d) arranged next to one another.

5. An apparatus according to claim 4 and comprising a left fan (8s), a central fan (8c), a right fan (8d) ; wherein the central fan (8c) comprises a pair of extended partitions (25), which are arranged on two sides separating the central fan (8c) from the left fan (8s) and from the right fan (8d); wherein each extended partition (25) comprises a curved portion (12), which is configured to screen a respective corner, in particular an upright (10), of the ventilation chamber (7); wherein the curved portions (12) of the extended partitions (25) are arranged at opposite corners, in particular in correspondence of opposite uprights (10), on a same diagonal of the ventilation chamber (7).

6. An air conditioning machine comprising a ventilation apparatus (5; 105) according to any of the preceding claims.

## Patentansprüche

1. Belüftungsvorrichtung, insbesondere für Klimaanlagen (1), bei denen Luft (W) von einer Niederdruckzone zu einer Hochdruckzone strömt, mit einer viereckigen Trägerstruktur (6), die eine oder mehrere Ventilationskammern (7) begrenzt, und einem Gebläse (8; 8c, 8s, 8d) für jede Ventilationskammer (7); wobei die Vorrichtung eine oder mehrere Trennwände (11; 25), die jeweils innerhalb der Ventilationskammer (7) so angebracht sind, dass sie den aus dem Gebläse (8; 8c, 8s, 8d) strömenden Luftstrom (W) entsprechend einer jeweiligen Ecke der Ventilationskammer (7) selbst radial ablenken, umfasst; wobei die Vorrichtung Flügel (14; 14I; 14II) mit einer Wand (15), die tangential zur Richtung der absoluten Geschwindigkeit des aus dem Gebläse (8; 8c, 8s, 8d) strömenden Luftstroms (W) verläuft, umfasst; wobei die Flügel eine Innenwand (15) und eine Außenwand (16) in einem Winkel relativ zueinander aufweisen; wobei die Vorrichtung (5, 105) **dadurch gekennzeichnet ist, dass** sie eine Vielzahl von Doppel- und Einzelflügeln (14; 14I; 14II), die in Übereinstimmung mit jeweiligen Öffnungen (01, 02, 03, 04) der Trägerstruktur (6) angeordnet sind, umfasst; wobei die Doppelflügel (14II) eine Innenwand (15), eine Außenwand (16) und ein Verbindungsstück (17) zwischen der Innenwand (15) und der Außenwand (16) aufweisen, wobei die Innenwand (15) tangential zur Richtung der absoluten Geschwindigkeit (v) des aus dem Gebläse (8; 8c, 8s, 8d) ausströmenden Luftstroms (W) verläuft; wobei die Außenwand (16) relativ zu der Innenwand in Abhängigkeit von der Richtung, die dem aus der jeweiligen Ventilationskammer (7) ausströmenden Luftstrom (W) gegeben werden soll, geneigt ist.

2. Belüftungsvorrichtung nach Anspruch 1, die eine Luftleitschaufel (13) umfasst, die im Inneren der jeweiligen Ventilationskammer (7) entsprechend einer Ecke installiert ist, die an diejenige angrenzt, an der die Trennwand (11; 25) angebracht ist; wobei die Kombination der Geometrie der Trennwand (11; 25) und der Luftleitschaufel (13) so konfiguriert ist, dass sie bewirkt, dass der aus dem Gebläse (8; 8c, 8s, 8d) strömende Luftstrom (W) einer Bewegung unterworfen wird, die der einer Schraubenspindelpumpe, nämlich der archimedischen Schraube, ähnlich ist.

3. Vorrichtung nach Anspruch 2, die ein Paar von Trennwänden (11; 25) und ein Paar von Luftleitschaufeln (13) umfasst; wobei die Trennwände (11; 25) an gegenüberliegenden Ecken auf einer gemeinsamen Diagonale der Ventilationskammer (7) angeordnet sind; wobei die Luftleitschaufeln (13) in der Nähe der anderen beiden gegenüberliegenden Ecken einer Diagonale angeordnet sind; wobei die aus den Trennwänden (11; 25) und den Luftleitschaufeln (13) gebildete Anordnung so konfiguriert ist, dass sie bewirkt, dass der aus dem Gebläse (8; 8c, 8s, 8d) strömende Luftstrom (W) einer Bewegung unterworfen wird, die die Bewegung der Luft (W) simuliert, die durch zwei Schraubenspindelpumpen, nämlich archimedische Schrauben, mit Verteilungsöffnungen, die einander gegenüberliegen und parallel zueinander sind, verursacht wird.

4. Vorrichtung nach einem der vorhergehenden Ansprüche, mit mehreren nebeneinander angeordneten Gebläsen (8; 8s, 8c, 8d).

5. Vorrichtung nach Anspruch 4 und umfassend ein linkes Gebläse (8s), ein zentrales Gebläse (8c), ein rechtes Gebläse (8d); wobei das zentrale Gebläse (8c) ein Paar von verlängerten Trennwänden (25) umfasst, die an zwei Seiten angeordnet sind und das zentrale Gebläse (8c) von dem linken Gebläse (8s) und von dem rechten Gebläse (8d) trennen; wobei jede verlängerte Trennwand (25) einen gekrümmten Abschnitt (12) umfasst, der so ausgebildet ist, dass er eine jeweilige Ecke, insbesondere einen Pfeiler (10), der Ventilationskammer (7) abschirmt, wobei die gekrümmten Abschnitte (12) der verlängerten Trennwände (25) an gegenüberliegenden Ecken, insbesondere in Übereinstimmung mit gegenüberliegenden Pfeilern (10), auf einer gemeinsamen Diagonale der Ventilationskammer (7) angeordnet sind.

6. Klimaanlage mit einer Belüftungsvorrichtung (5; 105) nach einem der vorhergehenden Ansprüche.

## Revendications

1. Appareil de ventilation, en particulier pour climatiseurs (1) impliquant le passage d'air (W) d'une zone de basse pression à une zone de haute pression, comprenant une structure de support quadrangulaire (6) qui délimite une ou plusieurs chambres de ventilation (7) et un ventilateur (8 ; 8c, 8s, 8d) pour chaque chambre de ventilation (7) ; l'appareil comprenant une ou plusieurs cloisons (11 ; 25), chacune montée à l'intérieur de la chambre de ventilation (7) afin de dévier radialement l'écoulement d'air (W) s'écoulant hors du ventilateur (8 ; 8c, 8s, 8d) en correspondance d'un coin respectif de la chambre de ventilation (7) elle-même ; l'appareil comprenant des ailettes (14 ; 14I ; 14II) ayant une paroi (15) qui est tangente à la direction de la vitesse absolue de l'écoulement d'air (W) s'écoulant hors du ventilateur (8 ; 8c, 8s, 8d) ; lesdites ailettes ayant une paroi interne (15) et une paroi externe (16) à un angle l'une par rapport à l'autre ; l'appareil (5 ; 105) étant **caractérisé en ce qu'**il comprend une pluralité d'ailettes doubles et simples (14 ; 14I ; 14II) agencées en correspondance des ouvertures (01, 02, 03, 04) respectives de la structure de support (6) ; dans lequel les doubles ailettes (14II) ont une paroi interne (15), une paroi externe (16) et un connecteur (17) entre la paroi interne (15) et la paroi externe (16) ; dans lequel la paroi interne (15) est tangente par rapport à la direction de la vitesse absolue (v) de l'écoulement d'air (W) s'écoulant hors du ventilateur (8 ; 8c, 8s, 8d) ; dans lequel la paroi externe (16) est inclinée par rapport à ladite paroi interne en fonction de la direction à donner à l'écoulement d'air (W) s'écoulant hors de la chambre de ventilation (7) respective.

2. Appareil de ventilation selon la revendication 1 et comprenant une pale (13) qui est installée à l'intérieur de la chambre de ventilation (7) respective en correspondance d'un coin qui est adjacent au coin où ladite cloison (11 ; 25) est montée ; dans lequel la combinaison de la géométrie de la cloison (11 ; 25) et de la pale (13) est configurée pour amener l'écoulement d'air (W) s'écoulant hors du ventilateur (8 ; 8c, 8s, 8d) à être soumis à un mouvement qui est similaire à celui d'une pompe à vis, à savoir une vis d'Archimède.

3. Appareil selon la revendication 2 et comprenant une paire de cloisons (11 ; 25) et une paire de pales (13) ; dans lequel les cloisons (11 ; 25) sont agencées au niveau des coins opposés sur une même diagonale de la chambre de ventilation (7) ; dans lequel les pales (13) sont agencées à proximité des deux autres coins opposés d'une diagonale ; dans lequel l'ensemble composé des cloisons (11 ; 25) et des pales (13) est configuré pour amener l'écoulement d'air (W) s'écoulant hors du ventilateur (8 ; 8c, 8s, 8d) à être soumis à un mouvement qui imite le mouvement de l'air (W) provoqué par deux pompes à vis, à savoir des vis d'Archimède, avec des ouvertures de distribution qui sont opposées et parallèles entre elles.

4. Appareil selon l'une quelconque des revendications précédentes et comprenant une pluralité de ventilateurs (8 ; 8s, 8c, 8d) agencés à proximité les uns des autres.

5. Appareil selon la revendication 4 et comprenant un ventilateur gauche (8s), un ventilateur central (8c), un ventilateur droit (8d) ; dans lequel le ventilateur central (8c) comprend une paire de cloisons (25) étendues qui sont agencées sur les deux côtés séparant le ventilateur central (8c) du ventilateur gauche (8s) et du ventilateur droit (8d) ; dans lequel chaque cloison (25) étendue comprend une partie incurvée (12) qui est configurée pour protéger un coin respectif, en particulier un montant (10), de la chambre de ventilation (7) ; dans lequel les parties incurvées (12) des cloisons (25) étendues sont agencées au niveau des coins opposés, en particulier en correspondance des montants (10) opposés, sur une même diagonale de la chambre de ventilation (7).

6. Climatiseur comprenant un appareil de ventilation (5 ; 105) selon l'une quelconque des revendications précédentes.
